(19) Europäisches Patentamt / European Patent Office / Office européen des brevets

(11) **EP 4 490 482 B1**

(12) **EUROPÄISCHE PATENTSCHRIFT**

(45) Veröffentlichungstag und Bekanntmachung des Hinweises auf die Patenterteilung:
**01.10.2025  Patentblatt 2025/40**

(21) Anmeldenummer: **23702573.9**

(22) Anmeldetag: **30.01.2023**

(51) Internationale Patentklassifikation (IPC):
**G01L 19/06** (2006.01)     **B81B 3/00** (2006.01)
**G01N 27/22** (2006.01)     **B81C 99/00** (2010.01)

(52) Gemeinsame Patentklassifikation (CPC):
**G01L 19/069; B81C 99/0035;** B81B 2201/0264;
B81B 2207/012

(86) Internationale Anmeldenummer:
**PCT/EP2023/052153**

(87) Internationale Veröffentlichungsnummer:
**WO 2023/169742 (14.09.2023 Gazette 2023/37)**

(54) **UMGEBUNGSSENSOR UND VERFAHREN ZUM BETREIBEN EINES UMGEBUNGSSENSORS**

ENVIRONMENTAL SENSOR AND METHOD OF OPERATING AN ENVIRONMENTAL SENSOR

CAPTEUR ENVIRONNEMENTAL ET MÉTHODE DE FONCTIONNEMENT D'UN CAPTEUR ENVIRONNEMENTAL

(84) Benannte Vertragsstaaten:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priorität: **08.03.2022  DE 102022202295**

(43) Veröffentlichungstag der Anmeldung:
**15.01.2025  Patentblatt 2025/03**

(73) Patentinhaber: **Robert Bosch GmbH
70442 Stuttgart (DE)**

(72) Erfinder:
• **SLOGSNAT, David
72074 Tuebingen (DE)**

• **MUSAZZI, Massimiliano
20149 Milano / Lombardia (IT)**
• **KREUTZER, Joachim
70469 Stuttgart (DE)**
• **SANTORO, Manuel Salvatore
20161 Milan (IT)**
• **TANGREDI, Domenico
20149 Milano (IT)**

(56) Entgegenhaltungen:
WO-A1-01/14895          WO-A1-2020/023414
DE-A1- 102020 212 123   DE-B3- 102020 206 952
US-A1- 2004 108 861

EP 4 490 482 B1

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung betrifft einen Umgebungssensor. Die Erfindung betrifft weiterhin ein Verfahren zum Betreiben eines Umgebungssensors. Die Erfindung betrifft ferner ein Computerprogrammprodukt.

Stand der Technik

Drucksensoren sind der äußeren Umgebung ausgesetzt, weshalb Flüssigkeiten mit ihnen in Kontakt kommen können. Dies kann zu Offsets in Druckmesswerten aufgrund der Zunahme der Masse, die durch die Anwesenheit der Flüssigkeit selbst erzeugt wird, führen.

Bekannt sind Selbsttests bei Sensoren, bei denen mittels einer Anregung eines MEMS-Elements eine nachfolgende Überprüfung von Messwerten durchgeführt wird.

WO 2020/023414 A1 offenbart ein Verfahren zur Flüssigkeitsdetektion in einer Sensorumgebung und Maßnahmen zum Entfernen der detektierten Flüssigkeit. Offenbart ist eine kapazitive Wasserdetektion auf einem gelgefüllten Sensorinneren.

US 10 640 367 B2, US 2004/0108861 A1 und US 2019/0383688 A1 offenbaren Sensoren mit kapazitiven Elektroden, mit denen abgelagerte Flüssigkeitstropfen aufgrund von einer geänderten Dielektrizitätskonstante der Umgebung detektiert werden können.

US 2020/0064215 A1 kombiniert die vorgenannten Ansätze, indem die Wasserdetektion über Kondensatoren erfolgt und Heizelemente verwendet werden, um den Wassertropfen nach erfolgter Detektion verdunsten zu lassen.

Offenbarung der Erfindung

Es ist eine Aufgabe der vorliegenden Erfindung, einen verbesserten Umgebungssensor bereitzustellen.

Die Aufgabe wird gemäß einem ersten Aspekt gelöst mit einem Umgebungssensor, aufweisend:

- ein MEMS-Element (MEMS: microelectromechanical system);
- ein mit dem MEMS-Element mittels wenigstens zweier Bonddrähte elektrisch verbundenes ASIC-Element (ASIC: application-specific integrated circuit), wobei das ASIC-Element eine Auswerteschaltung aufweist, welche ausgebildet ist, eine parasitäre Kapazität zwischen den wenigstens beiden an Pads des MEMS-Elements angeschlossenen Bonddrähten zu ermitteln und auszuwerten, um eine Materialablagerung am Umgebungssensor zu erfassen.

Bei dem Umgebungssensor kann, durch eine Kapazitätsmessung mittels der Auswerteschaltung des ASIC-Elements unter Verwendung von mit der Auswerteschaltung elektrisch verbundenen Bonddrähten, eine parasitäre Kapazität ermittelt werden, über die ein Vorhandensein einer Materialablagerung detektiert werden kann. Vorteilhaft können bereits existierende Bonddrähte des Umgebungssensors genutzt werden, wodurch Platz und Fläche eingespart werden kann. Auf diese Weise kann ein Vorhandensein einer Materialablagerung z.B. in Form von Flüssigkeit, Salzkruste, usw. am Umgebungssensor bzw. an dessen MEMS-Element ermittelt werden. Ausgenutzt wird dabei eine sich aufgrund der Materialablagerung ändernde Permittivität am Umgebungssensor, was mit einer Änderung der parasitären Kapazität einhergehen kann. Eine Auswertungssoftware kann z.B. im ASIC-Element festverdrahtet sein, mit der zum Beispiel ein Selbsttest des vorgeschlagenen Umgebungssensors durchgeführt werden kann, um seine Funktionsfähigkeit festzustellen.

Die Aufgabe wird gemäß einem zweiten Aspekt gelöst mit einem Verfahren zum Betreiben eines Umgebungssensors, wobei der Umgebungssensor ein MEMS-Element mit einem ersten Pad und einem zweiten Pad aufweist, wobei an das erste Pad ein erster Bonddraht und an das zweite Pad ein zweiter Bonddraht angeschlossen ist, aufweisend die Schritte:

- Anlegen eines elektrischen Ansteuersignals an den ersten Bonddraht, wobei der erste Bonddraht mit dem zweiten Bonddraht kapazitiv gekoppelt ist;
- Ermitteln einer zwischen den Bonddrähten ausgebildeten parasitären Kapazität;
- Auswerten der ermittelten parasitären Kapazität; und
- Signalisieren eines Ergebnisses der Auswertung.

Das vorgeschlagene Verfahren kann in der Fertigung oder im Feld genutzt werden, wobei in einem Fehlerfall der Umgebungssensor (z.B. ein Aufprallsensor im Automotive Bereich) getauscht wird, um dadurch Folgeschäden zu vermeiden.

Die Aufgabe wird gemäß einem dritten Aspekt gelöst mit einem Computerprogrammprodukt mit Programmcodemitteln, eingerichtet zur Durchführung des vorgeschlagenen Verfahrens, wenn es auf einem vorgeschlagenen Umgebungssensor abläuft oder auf einem computerlesbaren Datenträger gespeichert ist.

Vorteilhafte Weiterbildungen des vorgeschlagenen Umgebungssensors und des vorgeschlagenen Verfahrens sind Gegenstand von abhängigen Ansprüchen.

Das MEMS-Element kann eine Sensorstruktur bzw. Sensorschaltung aufweisen. Hierunter kann zum Beispiel eine kapazitive Wheatstone'sche Brückenschaltung fallen.

Hinsichtlich der durch die Auswerteschaltung des ASIC-Elements durchgeführten Auswertung besteht die Möglichkeit, das Erfassen der Materialablagerung anhand der zu einem Zeitpunkt ermittelten parasitären Kapazität bzw. anhand eines zugehörigen Messwerts und/oder anhand der über eine Zeitdauer ermittelten parasitären Kapazität bzw. anhand von mehreren zugehörigen Messwerten durchzuführen. Die Zeitdauer kann eine vorgegebene Zeitdauer sein. Mit Bezug auf letztere Variante kann das Erfassen der Materialablagerung auf der Grundlage einer zeitlichen Änderung der ermittelten parasitären Kapazität erfolgen. Sofern zum Beispiel in einer relativ kurzen Zeitdauer eine deutliche Kapazitätsänderung auftritt, kann eine Materialablagerung erkannt werden. Eine über einen längeren Zeitraum (zum Beispiel Jahre) stattfindende Änderung, zum Beispiel aufgrund von Alterungseffekten, kann demgegenüber nicht als Vorliegen einer Materialablagerung eingestuft werden.

Eine vorteilhafte Weiterbildung des Umgebungssensors sieht vor, dass eines der Pads des MEMS-Elements, an welches ein zum Ermitteln der parasitären Kapazität eingesetzter Bonddraht angeschlossen ist, funktional nicht an dem MEMS-Element verbunden ist.

Eine weitere vorteilhafte Weiterbildung des Umgebungssensors sieht vor, dass zwei Pads des MEMS-Elements, an welche jeweils ein zum Ermitteln der parasitären Kapazität eingesetzter Bonddraht angeschlossen ist, funktional nicht an dem MEMS-Element verbunden sind.

Mit Bezug auf die vorgenannten Ausgestaltungen, in welchen das MEMS-Element wenigstens ein funktional nicht an dem MEMS-Element verbundenes Pad aufweist, kann das betreffende Pad ein elektrisch nicht weiter verbundenes bzw. isoliertes Pad sein, und auch als Blindanschluss bezeichnet werden. Ein solches Pad kann elektrisch nicht mit der Sensorstruktur bzw. Sensorschaltung des MEMS-Elements verbunden sein. In entsprechender Weise kann ein an ein solches Pad angeschlossener Bonddraht ein an dem MEMS-Element offener Bonddraht sein, und auch als Blindleitung oder Blinddraht bezeichnet werden. Ein solcher Bonddraht kann elektrisch nicht mit der Sensorstruktur bzw. Sensorschaltung des MEMS-Elements, oder auch einer Masse bzw. einem Massepotenzial, verbunden sein.

Eine weitere vorteilhafte Weiterbildung des Umgebungssensors sieht vor, dass zwei Pads des MEMS-Elements, an welche jeweils ein zum Ermitteln der parasitären Kapazität eingesetzter Bonddraht angeschlossen ist, funktional an dem MEMS-Element verbunden sind. Diese Pads können an dem MEMS-Element elektrisch weiter verbunden sein, und mit wenigstens einer Komponente des MEMS-Elements wie der Sensorstruktur bzw. Sensorschaltung, oder auch mit einem Massepotenzial, elektrisch verbunden sein. Hierbei können die Pads Anschlusspads der Sensorstruktur bzw. Sensorschaltung sein. Vorteilhaft wird auf diese Weise auf bereits existierende Strukturen zurückgegriffen. Ein Aufwand zur Realisierung des vorgeschlagenen Umgebungssensor ist damit optimiert. Dies trifft zum Beispiel auf folgende Ausgestaltung zu.

Eine weitere vorteilhafte Weiterbildung des Umgebungssensors sieht vor, dass zwei Pads des MEMS-Elements, an welche jeweils ein zum Ermitteln der parasitären Kapazität eingesetzter Bonddraht angeschlossen ist, Anschlusspads einer kapazitiven Wheatstone'schen Brückenschaltung des MEMS-Elements sind. Die Auswerteschaltung ist hierbei ausgebildet, durch eine sich auf eine Referenzkapazität der kapazitiven Wheatstone'schen Brückenschaltung beziehende Kapazitätsmessung die parasitäre Kapazität zu ermitteln. In dieser Ausgestaltung kann ein Antriebssignal für die Wheatstone'sche Brückenschaltung zur Ermittlung der parasitären Kapazität genutzt werden. Das Antriebssignal kann von der Auswerteschaltung erzeugt und an einen der beiden für die Kapazitätsermittlung eingesetzten Bonddrähte angelegt werden. Hierbei kann des Weiteren ausgenutzt werden, dass die parasitäre Kapazität, welche zwischen den beiden Bonddrähten bestehen kann, in Form einer parallel zu der Referenzkapazität der Brückenschaltung geschalteten Kapazität vorliegen kann. Bei der durch die Auswerteschaltung durchgeführten Kapazitätsmessung kann daher eine Gesamtkapazität als Summe aus der festen Referenzkapazität und der parasitären Kapazität ermittelt werden, wodurch auf die parasitäre Kapazität rückgeschlossen werden kann. Das Ermitteln der Gesamtkapazität stellt damit ein Ermitteln der parasitären Kapazität dar. Entsprechend den obigen Ausführungen kann das Erfassen der Materialablagerung anhand der zu einem Zeitpunkt ermittelten Gesamtkapazität bzw. anhand eines zugehörigen Messwerts und/oder anhand der über eine Zeitdauer ermittelten Gesamtkapazität (also einer zeitlichen Änderung derselben) bzw. anhand von mehreren zugehörigen Messwerten erfolgen.

Weitere vorteilhafte Weiterbildungen des Umgebungssensors sehen vor, dass die Brückenschaltung eine Vollbrückenschaltung oder eine Halbbrückenschaltung ist.

Eine weitere vorteilhafte Weiterbildung des Umgebungssensors sieht vor, dass die Auswerteschaltung ausgebildet ist, mittels eines definierten Kapazitätswerts festzustellen, dass keinerlei Materialablagerung am Umgebungssensor vorhanden ist. Dies kann anhand eines Vergleichs der ermittelten parasitären Kapazität bzw. eines zugehörigen Messwerts mit dem definierten Kapazitätswert erfolgen. Der definierte Kapazitätswert kann ein vorab bekannter Vergleichswert oder Schwellenwert sein.

Die Auswerteschaltung kann ferner ausgebildet sein, einen Vergleich nicht nur unter Verwendung von einem, sondern von mehreren unterschiedlichen Vergleichs- bzw. Schwellenwerten durchzuführen. Diese können sich auf unterschiedliche Materialien beziehen. Auf diese Weise besteht die Möglichkeit, unterschiedliche Materialablagerungen zu erkennen.

Eine weitere vorteilhafte Weiterbildung des Umgebungssensors sieht vor, dass der Umgebungssensor ferner eine Signalisierungseinrichtung aufweist, mittels derer ein Vorliegen einer Materialablagerung signalisierbar ist. Ein Nutzer des Umgebungssensors kann damit auf einfache Weise erkennen, ob der Umgebungssensor in seiner ordnungsgemäßen Funktionalität beeinträchtigt ist oder nicht. Die Signalisierungseinrichtung kann durch die Auswerteschaltung des ASIC-Elements aktiviert werden. Die Signalisierung kann zum Beispiel optisch, akustisch und/oder haptisch erfolgen.

Eine weitere vorteilhafte Weiterbildung des Umgebungssensors sieht vor, dass die Auswerteschaltung ausgebildet ist, beim Erkennen von Flüssigkeit eine Einrichtung zur Entfernung von Flüssigkeit zu aktivieren. Beispielsweise kann in diesem Falle ein Heizer, ein Gebläse oder dergleichen aktiviert werden.

Weitere vorteilhafte Weiterbildungen des Umgebungssensors sehen vor, dass der Umgebungssensor wenigstens eines aus Folgendem ist: Flüssigkeitssensor, Drucksensor, Gassensor, Feuchtesensor, Mikrofon. Auf vorteilhafte Weise kann der vorgeschlagene Umgebungssensor in unterschiedlichsten Formen realisiert werden.

Hinsichtlich des vorgeschlagenen Verfahrens kann das Signalisieren optisch, akustisch und/oder haptisch erfolgen. Hierzu kann eine Signalisierungseinrichtung des Umgebungssensors aktiviert werden.

Ferner besteht die Möglichkeit, das Verfahren bzw. zumindest die Schritte des Anlegens des elektrischen Ansteuersignals, das Ermitteln der parasitären Kapazität und das Auswerten zu definierten Zeitpunkten und/oder zyklisch durchzuführen.

Die Erfindung wird im Folgenden mit weiteren Merkmalen und Vorteilen anhand von mehreren Figuren detailliert beschrieben. Die Figuren sind vor allem dazu gedacht, die erfindungswesentlichen Prinzipien zu verdeutlichen.

Offenbarte Verfahrensmerkmale ergeben sich analog aus entsprechenden offenbarten Vorrichtungsmerkmalen und umgekehrt. Dies bedeutet insbesondere, dass sich Merkmale, technische Vorteile und Ausführungen betreffend den Umgebungssensor in analoger Weise aus entsprechenden Ausführungen, Merkmalen und Vorteilen betreffend das Verfahren zum Betreiben eines Umgebungssensors ergeben und umgekehrt.

In den Figuren zeigt:

Fig. 1    eine Querschnittsansicht einer Ausführungsform eines vorgeschlagenen Umgebungssensors;

Fig. 2    eine Querschnittsansicht einer Ausführungsform eines vorgeschlagenen Umgebungssensors mit einer hervorgehobenen Detailansicht;

Fig. 3    ein prinzipielles Schaltbild einer ersten Ausführungsform eines vorgeschlagenen Umgebungssensors;

Fig. 4    ein prinzipielles Schaltbild einer zweiten Ausführungsform eines vorgeschlagenen Umgebungssensors;

Fig. 5    ein prinzipielles Schaltbild einer dritten Ausführungsform eines vorgeschlagenen Umgebungssensors;

Fig. 6    ein Messdiagramm bei Auftreten von Flüssigkeit am Umgebungssensor; und

Fig. 7    ein zeitliches Ablaufdiagramm mit einem prinzipiellen Ablauf eines vorgeschlagenen Verfahrens zum Betreiben eines Umgebungssensors.

Nachfolgend wird der vorgeschlagene Umgebungssensor 100 als ein Sensor mit einer kapazitiven Messsensorik näher erläutert. Dabei wird die Messgröße auf der Grundlage eines MEMS-Elements 10 erfasst, in dem sowohl variable Kapazitäten (aktive Messelemente) als auch Referenzkapazitäten verbaut sind. Darüber hinaus ist das MEMS-Element 10 entweder durch Gel oder Öl geschützt.

Vorgeschlagen wird ein Detektionsprinzip zur Erfassung von Materialablagerungen, bei dem das Vorhandensein einer Materialablagerung am Umgebungssensor 100 bewertet wird, wobei zu diesem Zweck eine Kapazitätsvariation einer Kapazität zwischen Bonddrähten zwischen MEMS-Element 10 und ASIC-Element 20 ermittelt und ausgewertet wird.

Nachfolgend wird eine Detektion einer Materialablagerung in Form von Flüssigkeit, insbesondere Wasser erläutert. Vorteilhaft kann das vorgeschlagene Verfahren aber auch zur Detektion von anderen unerwünschten Materialablagerungen, wie zum Beispiel Partikel, Fasern, Ablagerungen, Strukturen, Biofilme, Schweiß, Salz, usw. verwendet werden. Daher wird diese Kapazitätsvariation anhand der Druckmesskette gemessen, die bereits im ASIC-Element 20 implementiert ist.

Vorgeschlagen wird ein Umgebungssensor 100, der beispielsweise als ein barometrischer kapazitiver Drucksensor ausgebildet sein kann. Bei einem derartigen kapazitiven Sensor wird Druck mittels eines MEMS-Elements 10 erfasst, in dem sowohl variable Kapazitäten (die eigentlichen Druckmesselemente) als auch feste Referenzkapazitäten verbaut sind, und die in einer kapazitiven Wheatstone'schen Brückenschaltung angeordnet sind.

Vorteilhaft ist für das vorgeschlagene Verfahren keine dedizierte Signalverarbeitungskette erforderlich, sondern es kann die Erkennung der Materialablagerung mit einer spezifischen Konfiguration des ASIC-Elements 20 erreicht werden. Darüber hinaus befindet sich die Flüssigkeitsdetektion näher an der Geloberfläche, d.h. dort, wo eine Flüssigkeitsablagerung erwartet wird und die Sensorleistung am stärksten beeinträchtigt wird, als bei früheren Implementierungen. Damit ist dieses vorgeschlagene Konzept gut in der Lage, Materialablagerungen zu detektieren und/oder zu quantifizieren, wodurch im Falle einer Detektion geeignete Gegenmaßnahmen ergriffen werden können.

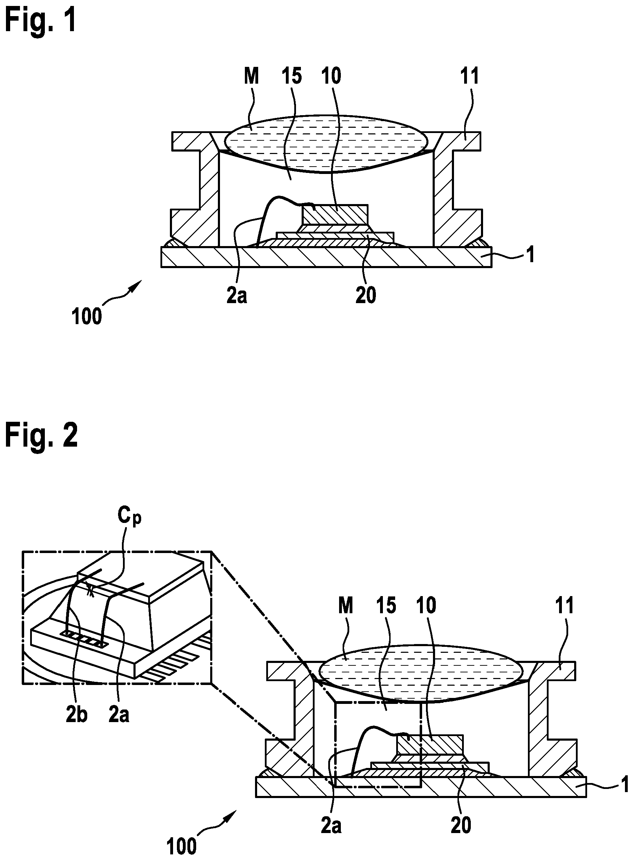

Fig. 1 zeigt eine Querschnittsansicht einer Ausführungsform eines vorgeschlagenen Umgebungssensors 100. Man erkennt auf einem Substrat 1 ein ASIC-Element 20, mit dem eine Signalauswertung durchgeführt werden kann. Auf dem ASIC-Element 20 ist ein MEMS-Element 10 angeordnet. Das ASIC-Element 20 und das MEMS-Element 10 können in Form von Halbleiterbauelementen bzw. Halbleiterchips verwirklicht sein. Das ASIC-Element 20 und das MEMS-Element 10 sind mittels wenigstens zweier Bonddrähte 2a, 2b miteinander elektrisch verbunden, welche an Kontaktflächen- bzw. Kontaktelemente das MEMS- und ASIC-Elements 10, 20, hier als Bondpads bzw. Pads bezeichnet, angeschlossen sind. Der Umgebungssensor 100 bzw. das MEMS- und ASIC-Element 10, 20 sind mittels eines Schutzelements 15 (z.B. Gel) geschützt. Man erkennt ferner, dass sich eine Materialablagerung M z.B. in Form von Wasser auf der Oberseite des Schutzelements 15 befindet, was eine Funktionsfähigkeit des Umgebungssensors 100 beeinträchtigen kann. Als Schutzelement 15 können auch Ölpufferlösungen (die z.B. in Hochdruckanwendungen, z.B. industrie- oder automobilen Anwendungsfällen verwendet werden) oder luftdurchlässige Membranlösungen (etabliert für Mikrofone / Akustikwandler) anstelle von Gel verwendet werden. Der Umgebungssensor 100 in Form eines kapazitiven Drucksensors ist ferner mittels eines Kappenelements 11 (z.B. Metalldeckel) abgedeckt und dadurch zusätzlich geschützt.

Denkbar sind auch andere, nicht in Figuren dargestellte Ausführungsformen des Umgebungssensors 100 mit anderen Anordnungen von MEMS- und ASIC-Element 10, 20.

Durch das Vorhandensein von Wasser (oder einem anderen abgelagerten Medium) ändert sich eine parasitäre Kapazität $C_p$ zwischen Bonddrähten 2a, 2b, die ermittelt und ausgewertet wird, wobei aufgrund dieser Auswertung auf ein Vorhandensein von Wasser (oder einem anderen Medium) am Umgebungssensor 100 geschlossen wird.

Zwischen jeweils zwei Bonddrähten 2a, 2b, die kapazitiv miteinander gekoppelt sind, bildet sich die genannte parasitäre Kapazität $C_p$ aus. Der Wert dieser Kapazität $C_p$ hängt von der Permittivität des umgebenden Materials ab. Wasser (und auch andere Medien) auf dem Schutzelement 15 oder sogar innerhalb des Schutzelements 15 (falls ein Medium im Schutzelement 15 löslich ist) können somit einen Kapazitätswert der parasitären Kapazität $C_p$ verändern, was beim vorgeschlagenen Verfahren ausgenutzt wird.

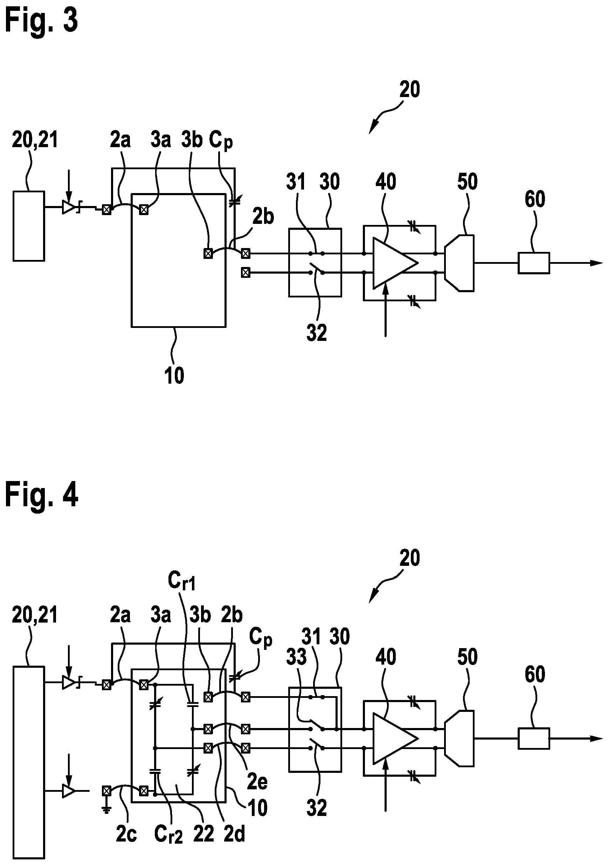

Bei der normalen Vollbrückenverbindung des MEMS-Elements 10 heben sich die Kapazitätsänderungen meist auf und können auf diese Weise nicht erkannt werden. In einer möglichen Realisierung des vorgeschlagenen Umgebungssensors 100, wie sie weiter unten anhand von Fig. 3 näher erläutert wird, werden zwei dedizierte Bonddrähte 2a, 2b verwendet, zwischen denen sich die betrachtete parasitäre Kapazität $C_p$ ausbildet. Die Bonddrähte 2a, 2b sind am MEMS-Element 10 offen, d.h. mit funktional nicht angeschlossenen Pads 3a, 3b des MEMS-Elements 10 verbunden. Die am MEMS-Element 10 funktional nicht angeschlossenen Pads 3a, 3b repräsentieren somit Blindanschlüsse, wohingegen die betreffenden Bonddrähte 2a, 2b elektrische Blindleitungen oder Blinddrähte darstellen. Die zwischen den Bonddrähten 2a, 2b vorliegende Kapazität kann von einem analogen Frontend des ASIC-Elements 20 ausgelesen werden. In einer anderen Realisierung gibt es nur einen unverbundenen bzw. offenen Bonddraht 2a, 2b, der zum MEMS-Element 10 führt, und die betrachtete Kapazität $C_p$ wird zwischen diesem Bonddraht und einem anderen Bonddraht gebildet, der als Verbindung zur Brückenschaltung 22 oder zu einem Massepotential GND dient. Dies wird weiter unten anhand von Fig. 4 näher erläutert.

Fig. 2 zeigt den Umgebungssensor 100 von Fig. 1 mit einer hervorgehobenen Detailansicht. In der hervorgehobenen Detailansicht ist erkennbar, dass sich zwischen den beiden dargestellten Bonddrähten 2a, 2b eine parasitäre Kapazität $C_p$ ausgebildet hat. Die parasitäre Kapazität $C_p$ kann je nach Vorhandensein von Material am Umgebungssensor 100 unterschiedlich groß sein und wird gemäß dem vorgeschlagenen Verfahren ermittelt und ausgewertet.

In diesem Zusammenhang kann zum Beispiel von einem definierten bzw. vorab bekannten Kapazitätswert ausgegangen werden, bei dem sich keinerlei Materialablagerung auf dem Umgebungssensor 100 befindet. Bei Vorliegen von anderen Kapazitätswerten der parasitären Kapazität $C_p$, was anhand des vorgeschlagenen Messverfahrens ermittelt werden kann, kann zum Beispiel auf das Vorhandensein von Wasser, Schweiß, Salz, oder anderen Materialien auf dem Umgebungssensor 100 geschlossen werden.

Vorteilhaft kann dadurch auf einfache Weise auf ein Vorhandensein von Material am Umgebungssensor 100 geschlossen werden, der durch das Material in seiner Funktionsfähigkeit beeinträchtigt sein kann, und daraufhin zum Beispiel eine Vorrichtung zur Beseitigung der Materialablagerung aktiviert, z.B. in Form einer Heizung, eines Gebläses, usw. (nicht dargestellt). Durch das Entfernen der Materialablagerung M kann die ordnungsgemäße Funktionsfähigkeit des Umgebungssensor 100 somit vorteilhaft wiederhergestellt werden. Denkbar ist aber auch eine Signalisierung (z.B. optisch, akustisch, haptisch) des Vorhandenseins der Materialablagerung M durch Aktivieren einer Signalisierungseinrichtung, sodass ein Anwender von sich aus initiativ werden kann, um die Materialablagerung M vom Umgebungssensor 100 zu entfernen.

Bei der normalen Vollbrückenschaltung des MEMS-Elements 10 heben sich die Kapazitätsänderungen meist auf und/oder können nicht von einer Druckänderung unterschieden werden und können daher nicht erkannt werden.

Im Folgenden werden mögliche Realisierungen des vorgeschlagenen Umgebungssensors 100 anhand von Schaltbildern näher erläutert.

In einer in Fig. 3 dargestellten ersten Realisierung des Umgebungssensors 100 werden zwei dedizierte Bonddrähte 2a, 2b verwendet, zwischen denen sich die parasitäre Kapazität $C_p$ ausgebildet hat. Die Bonddrähte 2a, 2b, im Folgenden auch als erster Bonddraht 2a und zweiter Bonddraht 2b bezeichnet, sind an Pads 3a, 3b des MEMS-Elements 10 angeschlossen, die am MEMS-Element 10 funktional nicht verschaltet sind, also nicht mit einer Sensorschaltung des MEMS-Elements 10 (Wheatstone'sche Brückenschaltung) oder einem Massepotenzial verbunden sind. Die zu ermittelnde Kapazität $C_p$ zwischen den Bonddrähten 2a, 2b kann z.B. von einem analogen Frontend des ASIC-Elements 20 ausgelesen werden.

Beim vorgeschlagenen Verfahren zum Betreiben des Umgebungssensors 100 wird mittels einer Antriebsschaltung 21 ein elektrisches Ansteuersignal an den ersten Bonddraht 2a angelegt. Der erste Bonddraht 2a ist mit dem zweiten Bonddraht 2b kapazitiv gekoppelt, sodass die parasitäre Kapazität $C_p$ zwischen den beiden Bonddrähten 2a, 2b besteht.

Man erkennt eine Schaltereinrichtung 30 mit einem Schalterelement 31, das mit dem zweiten Bonddraht 2b elektrisch verbunden ist und für die Messung der parasitären Kapazität $C_p$ in einen geschlossenen Schaltzustand versetzt wurde. Auf diese Weise kann über das Schalterelement 31 ein elektrisches Signal betreffend die zu ermittelnde Kapazität $C_p$ an eine Verstärkungseinrichtung 40 (z.B. low noise amplifier) übermittelt werden und nachfolgend an einen A/D-Wandler 50 (Anlog-Digital-Wandler bzw. ADC: analog-to-digital converter). Mittels eines nachfolgenden digitalen Signalprozessors 60 (DSP: digital signal processor) kann aus dem Signal ein Kapazitätswert der parasitären Kapazität $C_p$ ermittelt werden. Die Funktionsweise einer derartigen Signalverarbeitungskette ist an sich bekannt und wird deshalb hier nicht näher erläutert. Die Schaltereinrichtung 30, die Verstärkungseinrichtung 40, der A/D-Wandler 50 und der digitale Signalprozessor 60, welche in geeigneter Weise elektrisch miteinander verbunden sind, sind ebenso wie die Antriebsschaltung 21 Bestandteile des ASIC-Elements 20.

Im Folgenden werden weitere Ausgestaltungen des Umgebungssensors 100 beschrieben. Übereinstimmende Merkmale sowie gleiche und gleich wirkende Komponenten werden im Folgenden nicht erneut detailliert beschrieben. Für Details hierzu wird stattdessen auf die obige Beschreibung Bezug genommen. Ferner können Aspekte und Details, welche in Bezug auf eine Ausgestaltung genannt werden, auch in Bezug auf eine andere Ausgestaltung zur Anwendung kommen und können Merkmale von zwei oder mehreren Ausgestaltungen miteinander kombiniert werden.

In einer weiteren, in Fig. 4 dargestellten Ausführungsform des Umgebungssensors 100 gibt es nur einen unverbundenen bzw. offenen Bonddraht 2b, der an ein funktional nicht verbundenes Pad 3b des MEMS-Element 10 angeschlossen ist. Hierbei liegt die zu ermittelnde parasitäre Kapazität $C_p$ zwischen diesem zweiten Bonddraht 2b und einem ersten Bonddraht 2a vor. Der erste Bonddraht 2a dient als Verbindung zur kapazitiven Wheatstone'schen Brückenschaltung 22 des MEMS-Elements 10 und ist an ein mit der Brückenschaltung 22 verbundenes Pad 3a angeschlossen. Das Pad 3a bildet dabei ein Anschlusspad der Brückenschaltung 22. Vorteilhaft kann bei dieser Variante der Bonddraht 2a als eine elektrische Ansteuerleitung für die Wheatstone sche Brückenschaltung 22 genutzt werden. Man erkennt, dass in diesem Fall Schalterelemente 32, 33 der Schaltereinrichtung 30 offen sind, über die im Normalbetrieb zum Zweck einer Druckmessung Kapazitätswerte der kapazitiven Wheatstone'schen Brückenschaltung 22 über Bonddrähte 2d, 2e ausgelesen werden. Die Bonddrähte 2d, 2e sind an weitere Anschlusspads der Brückenschaltung 22 angeschlossen.

Bei den hier beschriebenen Varianten wird barometrischer Druck mittels des MEMS-Elements 10 erfasst, indem eine vollkapazitive Brückenschaltung in Form der Wheatstone'schen Brückenschaltung 22 implementiert ist. Zwei Elemente der Brückenschaltung 22 sind variable Kapazitäten und werden zur Druckmessung verwendet. Die anderen beiden Elemente sind Festkapazitäten $C_{r1}$, $C_{r2}$, die als Referenzkapazitäten verwendet werden. MEMS- und ASIC-Element 10, 20 sind durch mehrere Bonddrähte 2a...2e, die das ASIC-Element 20 und dessen Antriebsschaltung 21 mit der Brückenschaltung 22 verbinden, elektrisch miteinander verbunden. Mittels der Antriebsschaltung 21 des ASIC-Elements 20 wird ein elektrisches Ansteuersignal angelegt.

Bei der in Fig. 4 gezeigten Ausführungsform ist, entsprechend Fig. 3, zum Zweck der Ermittlung der parasitären Kapazität $C_p$ das mit dem zweiten Bonddraht 2b verbundene Schalterelement 31 der Schaltereinrichtung 30 geschlossen. Hierdurch kann, sofern mit der Antriebsschaltung 21 ein elektrisches Ansteuersignal an den ersten Bonddraht 2a angelegt wird, ein elektrisches Signal betreffend die parasitäre Kapazität $C_p$ über das Schalterelement 31 an die Signalverarbeitungskette umfassend die Verstärkungseinrichtung 40, den A/D-Wandler 50 und den digitalen Signalprozessor 60 übermittelt werden. Der digitale Signalprozessor 60 kann daraufhin einen Kapazitätswert der Kapazität $C_p$ bereitstellen.

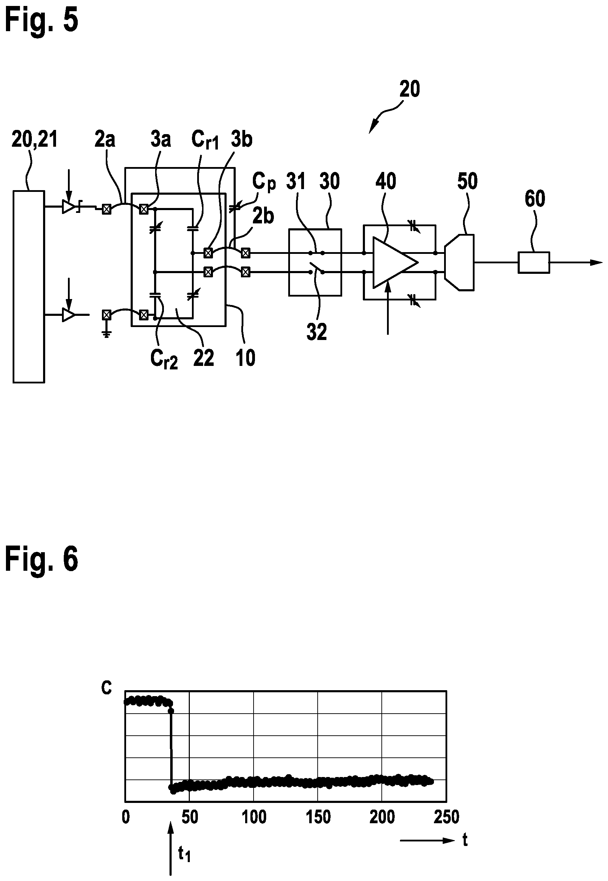

In einer dritten, in Fig. 5 dargestellten Ausführungsform des vorgeschlagenen Umgebungssensors 100 werden zwei Bonddrähte 2a, 2b zur Ermittlung der parasitären Kapazität $C_p$ verwendet, die mit der kapazitiven Wheatstone'schen Brückenschaltung 22 des MEMS-Elements 10 verbunden sind und im Normalbetrieb des Umgebungssensors 100 für Druckmessungen eingesetzt werden. Die Bonddrähte 2a, 2b sind an Pads 3a, 3b des MEMS-Elements 10 angeschlossen, welche am MEMS-Element 10 funktional verschaltet sind und Anschlusspads der Brückenschaltung 22 bilden.

Bei der in Fig. 5 gezeigten Variante erfolgt die Ermittlung der parasitären Kapazität $C_p$ auf der Grundlage einer sich auf die feste Referenzkapazität $C_{r1}$ der Wheatstone'schen Brückenschaltung 22 beziehende Kapazitätsmessung. Dabei wird ausgenutzt, dass die zwischen den Bonddrähten 2a, 2b vorliegende parasitäre Kapazität $C_p$ sich als parallel zu der Referenzkapazität $C_{r1}$ geschaltete Kapazität auswirken kann. Insofern kann eine Gesamtkapazität C in Form einer Summe aus der Referenzkapazität $C_{r1}$ und der parasitären Kapazität $C_p$ ermittelt werden, also gemäß folgender Formel:

$$C = C_{r1} + C_p \qquad (1)$$

mit:

C.... Gesamtkapazität
$C_{r1}$.... feste Referenzkapazität der Wheatstone'schen Brückenschaltung
$C_p$.... parasitäre Kapazität

Aufgrund der festen und bekannten Referenzkapazität $C_{r1}$ kann anhand der Gesamtkapazität C auf die parasitäre Kapazität $C_p$ rückgeschlossen werden. Das Ermitteln der parasitären Kapazität $C_p$ erfolgt somit durch bzw. ist gleichbedeutend mit einem Ermitteln der Gesamtkapazität C.

Wie in Fig. 5 gezeigt ist, wurde zum Zweck der Messung der Gesamtkapazität C und damit der parasitären Kapazität $C_p$, entsprechend Fig. 3, das mit dem zweiten Bonddraht 2b elektrisch verbundene Schalterelement 31 der Schaltereinrichtung 30 in einen geschlossenen Schaltzustand versetzt. Ein anderes Schalterelement 32 der Schaltereinrichtung 30, welches im Normalbetrieb zur Druckmessung geschlossen ist, befindet sich demgegenüber in einem offenen Schaltzustand. Sofern mit der Antriebsschaltung 21 ein elektrisches Ansteuersignal an den ersten Bonddraht 2a angelegt wird, kann auf diese Weise ein elektrisches Signal betreffend die Gesamtkapazität C über das Schalterelement 31 an die Signalverarbeitungskette umfassend die Verstärkungseinrichtung 40, den A/D-Wandler 50 und den digitalen Signalprozessor 60 übermittelt werden. Der digitale Signalprozessor 60 kann daraufhin einen von der Größe der parasitären Kapazität $C_p$ abhängigen Kapazitätswert der Gesamtkapazität C und und/oder einen Kapazitätswert der parasitären Kapazität $C_p$ bereitstellen.

Die vorgenannte Variante stellt die kostengünstigste Lösung dar, da hierfür kein zusätzlicher Bonddraht erforderlich ist und dadurch vorteilhaft Bonddrahtverbindungen und Siliziumfläche eingespart werden können. Um eine Materialablagerung M zu detektieren, wird der Umgebungssensor 100 also lediglich in einem spezifischen Messmodus betrieben, in dem im Vergleich zu einem Normalmodus eine Messung nur in Bezug auf eine der beiden Referenzkapazitäten $C_{r1}$, $C_{r2}$, d.h. vorliegend der Referenzkapazität $C_{r1}$, durchgeführt wird. Dabei ist das Schalterelement 32 geöffnet und die Messung der Gesamtkapazität C erfolgt über das geschlossene Schalterelement 31.

Das Erfassen einer Materialablagerung M am Umgebungssensor 100 kann anhand eines Messwerts der parasitären Kapazität $C_p$ (bzw. Gesamtkapazität C mit Bezug auf die Ausgestaltung von Fig. 5) erfolgen. Dabei kann z.B. ein Vergleich mit einem definierten oder vorab bekannten Kapazitätswert erfolgen, bei dem sich keinerlei Materialablagerung M auf dem Umgebungssensor 100 befindet. Zusätzlich oder alternativ besteht die Möglichkeit, das Erfassen einer Materialablagerung M anhand der über eine

Zeitdauer ermittelten parasitären Kapazität $C_p$ (bzw. Gesamtkapazität C mit Bezug auf Fig. 5), und insofern anhand mehrerer Messwerte derselben durchzuführen. Für den Fall, dass in einer relativ kurzen Zeitdauer eine deutliche Kapazitätsänderung stattfindet, kann eine Materialablagerung M erkannt werden.

Eine Auswertung, wie sie vorstehend beschrieben wurde, kann durch den digitalen Signalprozessor 60 des ASIC-Elements 20 durchgeführt werden. Sofern durch den Signalprozessor 60 auf diese Weise ein Vorliegen einer Materialablagerung M detektiert wird, kann durch den Signalprozessor 60 daraufhin z.B. eine Signalisierungseinrichtung zur Signalisierung der festgestellten Materialablagerung M und/oder eine Vorrichtung zur Beseitigung der Materialablagerung aktiviert werden (nicht dargestellt).

Ein Erfassen einer Materialablagerung M durch eine über die Zeit stattfindende Kapazitätsänderung wird im Folgenden mit Bezug die Ausgestaltung von Fig. 5 näher erläutert. In diesem Sinne kann eine Materialablagerung durch eine Messung der Gesamtkapazität C unter Verwendung folgender Formel ermittelt werden:

$$C(t) = C_{r1} + C_p(t) \qquad (2)$$

mit:

C.... Gesamtkapazität
$C_{r1}$.... feste Referenzkapazität der Wheatstone'schen Brückenschaltung
$C_p$.... parasitäre Kapazität
t.... Zeit

Zur Detektion der Materialablagerung M ist es ausreichend, eine Änderung der gemessenen Gesamtkapazität C zu erkennen, wobei eine in definiert kurzer Zeit ermittelte deutliche Änderung der Gesamtkapazität C einen Rückschluss auf eine entsprechende Änderung der parasitären Kapazität $C_p$ aufgrund einer Materialablagerung M erlaubt. Eine detektierte Änderung der Gesamtkapazität C kann dabei direkt (beispielsweise linear) einer Änderung der parasitären Kapazität $C_p$ aufgrund einer Materialablagerung M zugeordnet werden. Definierte Zahlenwerte können im Zuge von Abgleichsmessungen am Ende der Fertigung ermittelt werden und können zahlreiche Umstände (z.B. Sensormodell, Chargen, Materialeigenschaften, usw.) berücksichtigen.

Dies gilt zumindest für einzelne Messungen zu definierten Zeitpunkten in einem ausreichend kurzen Zeitraum (z.B. Tage, Wochen, Monate), so dass Alterungseffekte (z.B. Driften) über größere Zeiträume (z.B. Jahre) die Messungen vorteilhaft möglichst nicht beeinflussen können, sodass nicht ungewollt und fälschlicherweise Materialablagerungen detektiert werden. Es kann dabei z.B. ein Wert der Gesamtkapazität C definiert werden, bei dem keine Materialablagerung am Umgebungssensor 100 vorliegt, wobei nachfolgende Messwerte mit diesem definierten Wert der Gesamtkapazität C verglichen werden können, um festzustellen, ob nunmehr eine Materialablagerung M am Umgebungssensor 100 vorhanden ist oder nicht.

Fig. 6 zeigt zur Veranschaulichung rein qualitativ eine Änderung der Gesamtkapazität C, wenn zu einem Zeitpunkt $t_1$ ein Wassertropfen auf das Schutzelement 15 des Umgebungssensors 100 gelegt wird. Dies ist meiner deutlichen Änderung der parasitären Kapazität $C_p$ und damit der Gesamtkapazität C verbunden, und kann daher anhand einer entsprechenden Kapazitätsmessung zuverlässig erkannt werden.

Das vorgeschlagene Detektionsprinzip gilt ganz allgemein für Ausführungsformen, die sich von den vorgenannten unterscheiden, d.h. für Umgebungssensoren 100, die eine andere Anzahl an Pads 3a...3n aufweisen und die andere Drahtbondverbindungen zwischen dem MEMS-Element 10 und dem ASIC-Element 20 aufweisen. Darüber hinaus kann das vorgeschlagene Verfahren z.B. auch auf kapazitive Drucksensoren in Halbbrückentechnologie (nicht dargestellt) angewendet werden, d.h. bei denen nur eine feste und eine variable Kapazität implementiert sind.

Schließlich kann dieses Messkonzept auf alle Szenarien angewendet werden, in denen mindestens zwei Bonddrähte zwischen dem MEMS-Element 10 und dem ASIC-Element 20 vorhanden sind, unabhängig vom Zweck dieser Bonddrähte 2a, 2b.

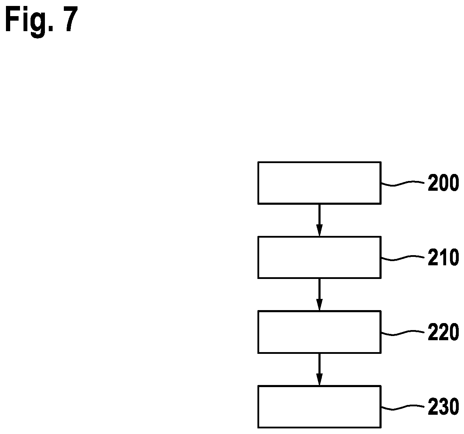

Fig. 7 zeigt ein Flussdiagramm eines Verfahrens zum Betreiben eines vorgeschlagenen Umgebungssensors 100.

In einem Schritt 200 erfolgt ein Anlegen eines elektrischen Ansteuersignals an den ersten Bonddraht 2a, wobei der erste Bonddraht 2a mit dem zweiten Bonddraht 2b kapazitiv gekoppelt ist.

In einem Schritt 210 erfolgt ein Ermitteln einer zwischen den Bonddrähten 2a, 2b ausgebildeten parasitären Kapazität $C_p$.

In einem Schritt 220 erfolgt ein Auswerten der ermittelten parasitären Kapazität $C_p$.

In einem Schritt 230 erfolgt ein Signalisieren eines Ergebnisses der Auswertung.

Das vorgeschlagene Verfahren kann z.B. in Form eines Selbsttests während der Produktionstests ausgeführt werden, um fehlerhafte Umgebungssensoren 100 auszusortieren. Es könnte optional auch später im Feld ausgeführt werden, um Fehler während der Lebensdauer des Umgebungssensors 100 zu erkennen. In diesem Fall kann ein Vergleichswert/Schwellenwert in der Produktionseinheit in einem nichtflüchtigen Speicher gespeichert werden. Der Vergleichswert/Schwellenwert repräsentiert dabei einen Kapazitätswert, bei dem keinerlei Materialablagerung am Umgebungssensor 100 vorhanden ist. Vergleichs- bzw. Schwellenwerte können vorzugsweise für unterschiedliche Materialien ermittelt werden, sodass auf einfache Weise mit unterschiedlichen Vergleichs- bzw. Schwellenwerten unterschiedliche Materialablagerungen erkannt werden können.

Das vorgeschlagene Verfahren kann vorzugsweise als eine wenigstens teilweise auf dem ASIC-Element 20 oder wenigstens teilweise extern davon ausgeführte Software ausgebildet sein, wodurch eine einfache Adaptierbarkeit des Verfahrens unterstützt ist. Alternativ kann das vorgeschlagene Verfahren wenigstens teilweise oder auch vollständig in Hardware realisiert sein.

Vorteilhaft kann das vorgeschlagene Verfahren als ein Computerprogramm realisiert werden, welches auf dem ASIC-Element 20 des Umgebungssensors 100 abläuft oder auf einem computerlesbaren Datenträger gespeichert ist.

Zusammenfassend wird mit der vorliegenden Erfindung ein Umgebungssensor 100 und ein Verfahren zum Betreiben eines Umgebungssensors 100 vorgeschlagen, mit denen auf einfache Weise ein Test auf das Vorhandensein einer Materialablagerung M möglich ist, wodurch vorteilhaft ein Status des Umgebungssensors 100 und eine Zulässigkeit von Messvorgängen beurteilt werden können.

**Patentansprüche**

1. Umgebungssensor (100), aufweisend:

   - ein MEMS-Element (10);
   - ein mit dem MEMS-Element (10) mittels wenigstens zweier Bonddrähte (2a, 2b) elektrisch verbundenes ASIC-Element (20), wobei das ASIC-Element (20) eine Auswerteschaltung (40, 50, 60) aufweist,

   **dadurch gekennzeichnet, dass**
   die Auswerteschaltung (40, 50, 60) ausgebildet ist, eine parasitäre Kapazität ($C_p$) zwischen den wenigstens beiden an Pads (3a, 3b) des MEMS-Elements (10) angeschlossenen Bonddrähten (2a, 2b) zu ermitteln und auszuwerten, um eine Materialablagerung am Umgebungssensor (100) zu erfassen.

2. Umgebungssensor (100) nach Anspruch 1, wobei eines der Pads (3b) des MEMS-Element (10), an welches ein zum Ermitteln der parasitären Kapazität ($C_p$) eingesetzter Bonddraht (2b) angeschlossen ist, funktional nicht an dem MEMS-Element (10) verbunden ist.

3. Umgebungssensor (100) nach Anspruch 1, wobei zwei Pads (3a, 3b) des MEMS-Element (10), an welche jeweils ein zum Ermitteln der parasitären Kapazität ($C_p$) eingesetzter Bonddraht (2a, 2b) angeschlossen ist, funktional nicht an dem MEMS-Element (10) verbunden sind.

4. Umgebungssensor (100) nach Anspruch 1, wobei zwei Pads (3a, 3b) des MEMS-Element (10), an welche jeweils ein zum Ermitteln der parasitären Kapazität ($C_p$) eingesetzter Bonddraht (2a, 2b) angeschlossen ist, funktional an dem MEMS-Element (10) verbunden sind.

5. Umgebungssensor (100) nach einem der Ansprüche 1 oder 4, wobei zwei Pads (3a, 3b) des MEMS-Elements (10), an welche jeweils ein zum Ermitteln der parasitären Kapazität ($C_p$) eingesetzter Bonddraht (2a, 2b) angeschlossen ist, Anschlusspads einer kapazitiven Wheatstone'schen Brückenschaltung (22) des MEMS-Elements (10) sind, und wobei die Auswerteschaltung (40, 50, 60) ausgebildet ist, durch eine sich auf eine Referenzkapazität ($C_{r1}$) der kapazitiven Wheatstone'schen Brückenschaltung (22) beziehende Kapazitätsmessung die parasitäre Kapazität ($C_p$) zu ermitteln.

6. Umgebungssensor (100) nach Anspruch 5, wobei die Brückenschaltung eine Vollbrückenschaltung oder eine Halbbrückenschaltung ist.

7. Umgebungssensor (100) nach einem der vorhergehenden Ansprüche, wobei die Auswerteschaltung (40, 50, 60) ausgebildet ist, mittels eines definierten Kapazitätswerts festzustellen, dass keinerlei Materialablagerung am Umgebungssensor (100) vorhanden ist.

8. Umgebungssensor (100) nach einem der vorhergehenden Ansprüche, wobei der Umgebungssensor (100) ferner eine Signalisierungseinrichtung aufweist, mittels derer ein Vorliegen einer Materialablagerung signalisierbar ist.

9. Umgebungssensor (100) nach einem der vorhergehenden Ansprüche, wobei die Auswerteschaltung (40, 50, 60) ausgebildet ist, beim Erkennen von Flüssigkeit eine Einrichtung zur Entfernung von Flüssigkeit zu aktivieren.

10. Umgebungssensor (100) nach einem der vorhergehenden Ansprüche, wobei der Umgebungssensor (100) wenigstens eines aus Folgendem ist: Flüssigkeitssensor, Drucksensor, Gassensor, Feuchtesensor, Mikrofon.

11. Verfahren zum Betreiben eines Umgebungssensors (100), wobei der Umgebungssensor (100) ein MEMS-Element (10) mit einem ersten Pad (3a) und einem zweiten Pad (3b) aufweist, wobei an das erste Pad (3a) ein erster Bonddraht (2a) und an das zweite Pad (3b) ein zweiter Bonddraht (2b) angeschlossen ist, aufweisend die Schritte:

- Anlegen eines elektrischen Ansteuersignals an den ersten Bonddraht (2a), wobei der erste Bonddraht (2a) mit dem zweiten Bonddraht (2b) kapazitiv gekoppelt ist;
- Ermitteln einer zwischen den Bonddrähten (2a, 2b) ausgebildeten parasitären Kapazität ($C_p$);

**dadurch gekennzeichnet, dass** das Verfahren folgende weitere Schritte aufweist:

- Auswerten der ermittelten parasitären Kapazität ($C_p$), um eine Materialablagerung am Umgebungssensor (100) zu erfassen; und

- Signalisieren eines Ergebnisses der Auswertung.

12. Verfahren nach Anspruch 11, wobei zumindest die Schritte des Anlegens des elektrischen Ansteuersignals, das Ermitteln der parasitären Kapazität und das Auswerten zu definierten Zeitpunkten und/oder zyklisch durchgeführt werden.

13. Computerprogramm mit Programmcodemitteln eingerichtet zur Durchführung des Verfahrens nach Anspruch 11 oder 12, wenn es auf einem ASIC-Element (20) eines Umgebungssensors (100) abläuft oder auf einem computerlesbaren Datenträger gespeichert ist.

**Claims**

1. Surroundings sensor (100), comprising:

- a MEMS element (10);
- an ASIC element (20) electrically connected to the MEMS element (10) by way of at least two bond wires (2a, 2b), wherein the ASIC element (20) comprises an evaluation circuit (40, 50, 60),

**characterized in that**
the evaluation circuit (40, 50, 60) is designed to ascertain and evaluate a parasitic capacitance ($C_p$) between the at least two bond wires (2a, 2b), which are connected to pads (3a, 3b) of the MEMS element (10), in order to detect a material deposition on the surroundings sensor (100).

2. Surroundings sensor (100) according to Claim 1, wherein one of the pads (3b) of the MEMS element (10), to which pad a bond wire (2b) used to ascertain the parasitic capacitance ($C_p$) is connected, is not functionally connected to the MEMS element (10).

3. Surroundings sensor (100) according to Claim 1, wherein two pads (3a, 3b) of the MEMS element (10), to each of which pads a bond wire (2a, 2b) used to ascertain the parasitic capacitance ($C_p$) is connected, are not functionally connected to the MEMS element (10).

4. Surroundings sensor (100) according to Claim 1, wherein two pads (3a, 3b) of the MEMS element (10), to each of which pads a bond wire (2a, 2b) used to ascertain the parasitic capacitance ($C_p$) is connected, are functionally connected to the MEMS element (10).

5. Surroundings sensor (100) according to one of Claims 1 or 4, wherein two pads (3a, 3b) of the MEMS element (10), to each of which pads a bond wire (2a, 2b) used to ascertain the parasitic capacitance ($C_p$) is connected, are connection pads of a capacitive Wheatstone bridge circuit (22) of the MEMS element (10), and wherein the evaluation circuit (40, 50, 60) is designed to ascertain the parasitic capacitance ($C_p$) by way of a capacitance measurement relating to a reference capacitance ($C_{r1}$) of the capacitive Wheatstone bridge circuit (22).

6. Surroundings sensor (100) according to Claim 5, wherein the bridge circuit is a full-bridge circuit or a half-bridge circuit.

7. Surroundings sensor (100) according to one of the preceding claims, wherein the evaluation circuit (40, 50, 60) is designed to establish, by way of a defined capacitance value, that no material deposition is present on the surroundings sensor (100).

8. Surroundings sensor (100) according to one of the preceding claims, wherein the surroundings sensor (100) furthermore comprises a signalling device able to be used to signal the presence of a material deposition.

9. Surroundings sensor (100) according to one of the preceding claims, wherein the evaluation circuit (40, 50, 60) is designed, in the event of liquid being detected, to activate a liquid removal device.

10. Surroundings sensor (100) according to one of the preceding claims, wherein the surroundings sensor (100) is at least one of the following: liquid sensor, pressure sensor, gas sensor, moisture sensor, microphone.

11. Method for operating a surroundings sensor (100), wherein the surroundings sensor (100) comprises a MEMS element (10) having a first pad (3a) and a second pad (3b), wherein a first bond wire (2a) is connected to the first pad (3a) and a second bond wire (2b) is connected to the second pad (3b), comprising the following steps:

- applying an electrical actuation signal to the first bond wire (2a), wherein the first bond wire (2a) is capacitively coupled to the second bond wire (2b);
- ascertaining a parasitic capacitance ($C_p$) formed between the bond wires (2a, 2b);

**characterized in that** the method comprises the following further steps:

- evaluating the ascertained parasitic capacitance ($C_p$) in order to detect a material deposition on the surroundings sensor (100); and
- signalling a result of the evaluation.

12. Method according to Claim 11, wherein at least the steps of applying the electrical actuation signal, ascertaining the parasitic capacitance and evaluating are performed at defined times and/or cyclically.

13. Computer program comprising program code means, configured to perform the method according to Claim 11 to 12 when it runs on an ASIC element (20) of a surroundings sensor (100) or is stored on a computer-readable data carrier.

**Revendications**

1. Capteur d'environnement (100), présentant :

- un élément MEMS (10) ;
- un élément ASIC (20) relié électriquement à l'élément MEMS (10) au moyen d'au moins deux fils de liaison (2a, 2b), l'élément ASIC (20) présentant un circuit d'évaluation (40, 50, 60),

**caractérisé en ce que**
le circuit d'évaluation (40, 50, 60) est réalisé pour déterminer et évaluer une capacité parasite ($C_p$) entre les au moins deux fils de liaison (2a, 2b) raccordés à des plots (3a, 3b) de l'élément MEMS (10), afin de détecter un dépôt de matière sur le capteur d'environnement (100).

2. Capteur d'environnement (100) selon la revendication 1, dans lequel l'un des plots (3b) de l'élément MEMS (10), auquel est raccordé un fil de liaison (2b) utilisé pour déterminer la capacité parasite ($C_p$), n'est pas relié fonctionnellement à l'élément MEMS (10).

3. Capteur d'environnement (100) selon la revendication 1, dans lequel deux plots (3a, 3b) de l'élément MEMS (10), auxquels est raccordé respectivement un fil de liaison (2a, 2b) utilisé pour déterminer la capacité parasite ($C_p$), ne sont pas reliés fonctionnellement à l'élément MEMS (10).

4. Capteur d'environnement (100) selon la revendication 1, dans lequel deux plots (3a, 3b) de l'élément MEMS (10), auxquels est raccordé respectivement un fil de liaison (2a, 2b) utilisé pour déterminer la capacité parasite ($C_p$), sont reliés fonctionnellement à l'élément MEMS (10).

5. Capteur d'environnement (100) selon l'une quelconque des revendications 1 ou 4, dans lequel deux plots (3a, 3b) de l'élément MEMS (10), auxquels est raccordé respectivement un fil de liaison (2a, 2b) utilisé pour déterminer la capacité parasite ($C_p$), sont des plots de raccordement d'un circuit capacitif en pont de Wheatstone (22) de l'élément MEMS (10), et dans lequel le circuit d'évaluation (40, 50, 60) est réalisé pour déterminer la capacité parasite ($C_p$) par une mesure de capacité se rapportant à une capacité de référence ($C_{r1}$) du circuit capacitif en pont de Wheatstone (22).

6. Capteur d'environnement (100) selon la revendication 5, dans lequel le circuit en pont est un circuit en pont complet ou un circuit en demi-pont.

7. Capteur d'environnement (100) selon l'une quelconque des revendications précédentes, dans lequel le circuit d'évaluation (40, 50, 60) est réalisé pour constater, au moyen d'une valeur de capacité définie, qu'aucun dépôt de matière n'est présent sur le capteur d'environnement (100).

8. Capteur d'environnement (100) selon l'une quelconque des revendications précédentes, le capteur d'environnement (100) présentant en outre un dispositif de signalisation au moyen duquel la présence d'un dépôt de matière peut être signalée.

9. Capteur d'environnement (100) selon l'une quelconque des revendications précédentes, dans lequel le circuit d'évaluation (40, 50, 60) est réalisé pour activer un dispositif d'élimination de liquide lors de la détection de liquide.

10. Capteur d'environnement (100) selon l'une quelconque des revendications précédentes, dans lequel le capteur d'environnement (100) est au moins l'un des suivants : un capteur de liquide, un capteur de pression, un capteur de gaz, un capteur d'humidité, un microphone.

11. Procédé d'exploitation d'un capteur d'environnement (100), le capteur d'environnement (100) présentant un élément MEMS (10) avec un premier plot (3a) et un deuxième plot (3b), un premier fil de liaison (2a) étant raccordé au premier plot (3a) et un deuxième fil de liaison (2b) étant raccordé au deuxième plot (3b), présentant les étapes suivantes :

   - l'application d'un signal électrique de commande au premier fil de liaison (2a), le premier fil de liaison (2a) étant couplé de manière capacitive au deuxième fil de liaison (2b) ;
   - la détermination d'une capacité parasite ($C_p$) réalisée entre les fils de liaison (2a, 2b) ;

   **caractérisé en ce que** le procédé comprend les étapes supplémentaires suivantes :

   - l'évaluation de la capacité parasite ($C_p$) déterminée afin de détecter un dépôt de matière sur le capteur d'environnement (100) ; et
   - la signalisation d'un résultat de l'évaluation.

12. Procédé selon la revendication 11, dans lequel au moins les étapes d'application du signal électrique de commande, de détermination de la capacité parasite et d'évaluation sont effectuées à des instants définis et/ou de manière cyclique.

13. Programme informatique avec des moyens de code de programme adaptés pour l'exécution du procédé selon la revendication 11 ou 12, lorsqu'il s'exécute sur un élément ASIC (20) d'un capteur d'environnement (100) ou qu'il est enregistré sur un support de données lisible par ordinateur.

EP 4 490 482 B1

# Fig. 1

# Fig. 2

# Fig. 3

# Fig. 4

EP 4 490 482 B1

# Fig. 5

# Fig. 6

14

**Fig. 7**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2020023414 A1
- US 10640367 B2
- US 20040108861 A1
- US 20190383688 A1
- US 20200064215 A1